# EUROPEAN PATENT APPLICATION

(11) **EP 4 770 368 A1**
(43) Date of publication of application: **01.07.2026**
(21) Application number: 25216239.1
(22) Date of filing: 17.11.2025
(51) Int. Cl.: H10K 59/122, H10K 59/124, H10K 59/80

(54) **LIGHT EMITTING DISPLAY DEVICE**

(30) Priority: 30.12.2024 KR 20240201471
(71) Applicant: LG Display Co., Ltd., Seoul, 07336 (KR)
(72) Inventor: BAN, MyungHo, 10845 Paju-si (KR); LEE, KyungEon, 10845 Paju-si (KR); KIM, KyungMin, 10845 Paju-si (KR)
(74) Representative: Ter Meer Steinmeister & Partner

(57) **Abstract**

A light emitting display device comprises: a substrate, an insulating layer, a planarization layer, a first anode electrode, a trench, a second anode electrode, an emission layer and a cathode electrode. The substrate has a first pixel and a second pixel. The insulating layer covers the first pixel and the second pixel on the substrate. The planarization layer is disposed on the insulating layer in the first pixel, and has a protrusion extruding upward. The first anode electrode is disposed on an upper surface of the protrusion of the planarization layer in the first pixel. The trench has a slit shape at a circumferential area of the second pixel by removing some portions of the insulating layer. The second anode electrode is disposed on the insulating layer in the second pixel. The emission layer is disposed on the first anode electrode and the second anode electrode. The cathode electrode is disposed on the emission layer.

## Description

This application claims priority to Korean Patent Application No. 10-2024-0201471, filed on December 30, 2024.

### BACKGROUND

### Field of the Invention

The present disclosure relates to a light emitting display device. In particular, the present disclosure relates to a bottom emission type light emitting display device having micro mirrors to enhance the light extraction efficiency.

### Discussion of the Related Art

Among the display devices, light emitting display devices can have the advantages of a wide viewing angle, excellent contrast, and fast response speed. The light emitting elements used in a light emitting display device can have a light emitting layer made of organic or inorganic material between an anode electrode and a cathode electrode. In these light emitting elements, holes are supplied from the anode electrode and electrons are supplied from the cathode electrode, whereafter the electrons and holes combine at the emission layer to generate excitons. As the excitons change from the excited state to the ground state, fluorescent molecules in the emission layer can emit light to express color.

However, some of the light emitted from the emission layer of the light emitting display device may not be emitted to the outside and can be lost due to total reflection within the electrode layer having a high refractive index, or due to total reflection occurring at the interface between the emission layer and the electrodes and/or the interface between the substrate and the air. This can result in a problem of reduced light extraction efficiency.

To overcome these problems, methods are being developed to improve the light extraction efficiency of light emitting devices by forming microlenses or microcavity structures inside the devices. However, although these structures improve the luminous efficiency of light emitted in the vertical direction of the display device, these structures cannot extract light emitted in the horizontal direction to the vertical direction. Therefore, existing methods have limitations in improving light extraction efficiency.

### SUMMARY OF THE DISCLOSURE

It is an object of the present invention to at least reduce the problems described above. There is an object of the present invention to provide a bottom emission type light emitting display device maximizing light extraction efficiency. Another object of the present invention is to provide a bottom emission type light emitting display device improving luminance maintenance factor and light extraction efficiency. Still another object of the present invention is to provide a bottom emission type light emitting display device in which the light loss due to a planarization layer in the white pixel is minimized.

At least one of the above objects is solved by a light emitting display device having the features of the independent claims.

In one aspect of the present invention, a light emitting display device includes: a substrate, an insulating layer, a planarization layer, a first anode electrode, a trench, a second anode electrode, an emission layer and a cathode electrode. The substrate has a first pixel and a second pixel. The insulating layer covers the first pixel and the second pixel on the substrate. The planarization layer is disposed on the insulating layer in the first pixel area and has a protrusion extruding upward. The first anode electrode is disposed on an upper surface of the protrusion of the planarization layer in the first pixel. The trench has a slit shape between the first pixel area and the second pixel area that penetrates the insulating layer. The trench may have a slit shape at a circumferential area of the second pixel by removing some portions of the insulating layer. The second anode electrode is disposed on the insulating layer in the second pixel and spaced apart from the planarization layer. The emission layer is disposed on the first anode electrode and the second anode electrode. The cathode electrode is disposed on the emission layer. The cathode electrode forms a first concave mirror facing the substrate directly above the first anode electrode. A portion of the cathode electrode is disposed in the trench.

In another aspect of the present invention, a light emitting display device includes: a substrate, a first color filter, a planarization layer, a first anode electrode, a second anode electrode, an emission layer and a cathode electrode. The substrate has a first pixel in a first pixel area and a second pixel in a second pixel area. The first color filter is disposed in the first pixel area. The planarization layer is disposed on the first color filter in the first pixel area and has a protrusion extruding upward. The first anode electrode is disposed on an upper surface of the protrusion of the planarization layer in the first pixel. The second anode electrode is disposed in the second pixel area and spaced apart from the planarization layer. The emission layer is disposed on the first anode electrode and the second anode electrode. The cathode electrode is disposed on the emission layer in the first pixel area and the second pixel area. The cathode electrode forms a concave mirror facing the substrate directly above the first anode electrode. The cathode electrode forms another concave mirror facing the substrate directly above the second anode electrode. Optionally, the cathode electrode may cover an upper surface of the planarization layer, a side wall of the protrusion, and/or an upper surface of the first anode electrode in the first pixel. Optionally, the cathode electrode may have an inclined surface at the side wall of the protrusion with respect to a horizontal surface of the substrate with an inclination angle θ in a range of 40 degrees to 80 degrees, preferably in the range of 50 degrees to 75 degrees. Optionally, the first pixel may be selected one of a red pixel, a green pixel and a blue pixel. Optionally, the second pixel may be a white pixel. Optionally, the light emitting display device may comprise an insulating layer disposed on the substrate in the first pixel and the second pixel area. Optionally, the light emitting display device may comprise a trench having a slit shape between the first pixel and the second pixel that penetrates the insulating layer. Optionally, a portion of the cathode electrode may be disposed in the trench. Optionally, the trench may expose a portion of the substrate. Optionally, a portion of the emission layer may directly contact the substrate.

The light emitting display device according to any of the preceding aspects may comprise one or more of the following features:

The concave mirror may be also referred to as cap shaped micro mirror, or simply as micro mirror structure. The term concave may refer to a direction towards the substrate. When viewed in a direction away from the substrate, the micro mirror (structure) may have a convex shape.

The insulating layer may comprise an intermediate insulating layer and a gate insulating layer. The trench and/or the slit shape of the trench may penetrate the intermediate insulating layer. Additionally, the trench and/or the slit shape of the trench may penetrate both the intermediate insulating layer and the gate insulating layer. The trench may be slit-shaped.

The emission layer may cover one or more of an upper surface of the planarization layer, a side wall of the protrusion, and an upper surface of the first anode electrode in the first pixel. The emission layer may cover one or more of the trench, an etched side wall of the insulating layer and an upper surface of the second anode electrode. The cathode electrode may be in surface contact with the emission layer.

The light emitting display device may comprise an etch stopper layer between the second anode electrode and the insulating layer in the second pixel. The etch stopper layer may be configured to form the trench. The etch stop layer may include a material having higher anti-etching property than the insulating layer against an etchant for patterning the insulating layer to form the trench.

The second anode electrode may have shorter length than the etch stopper layer. The second anode electrode may be disposed at a middle portion of the etch stopper layer. The second anode electrode may be centered on the etch stopper layer. The emission layer may have a step shape along the etch stopper layer and the second anode electrode in the second pixel. The lengths of the second anode electrode and the etch stopper layer may be defined in a cross-sectional direction. In the cross-sectional direction, the etch stopper layer may protrude on either side of the second anode electrode with respect to the second anode electrode.

The insulating layer may have an under-cut area which has a smaller area than the etch stopper layer and is over etched under the etch stopper layer from the trench. In the second pixel, the insulation layer may have a smaller area horizontal to the substrate than the etch stopper layer. The insulating layer may be over etched under the etch stopper layer to reduce its area with respect to the etch stopper layer. As a result, the under-cut area may be formed.

The emission layer may be disconnected at the under-cut area between the first pixel and the second pixel.

The first pixel may be selected one of a red pixel, a green pixel and a blue pixel. The second pixel may be a white pixel.

The white pixel may be disposed at any one of between the red pixel and the green pixel, between the green pixel and the blue pixel, and between the blue pixel and the red pixel.

The light emitting display device may comprise a color filter layer between the planarization layer and the insulating layer. The light emitting display device may comprise a driving element layer between the planarization layer and the substrate.

The driving element layer may be a layer configuring a thin film transistor on the substrate.

The color filter layer may include a red color filter, a green color filter, and a blue color filter. The first pixel, except the second pixel, may include any one of the red color filter, the green color filter, and the blue color filter.

The driving element layer may include a first driving element connected to the first anode electrode. The driving element layer may include a second driving element connected to the second anode electrode.

At least one of the first driving element and the second driving element, preferably the first driving element and the second driving element, may include a gate electrode on the substrate. At least one of the first driving element and the second driving element, preferably the first driving element and the second driving element, may include a gate insulating layer covering the gate electrode. At least one of the first driving element and the second driving element, preferably the first driving element and the second driving element, may include a semiconductor layer overlapping with the gate electrode on the gate insulating layer. At least one of the first driving element and the second driving element, preferably the first driving element and the second driving element, may include an intermediate insulating layer covering the semiconductor layer. At least one of the first driving element and the second driving element, preferably the first driving element and the second driving element, may include a source electrode connected to one side of the semiconductor layer and a drain electrode connected to another side of the semiconductor layer on the intermediate insulating layer. At least one of the first driving element and the second driving element, preferably the first driving element and the second driving element, may include a passivation layer covering the source electrode and the drain electrode.

The planarization layer may be disposed within the first pixel except the second pixel. The trench may be disposed or formed between a side wall of the planarization layer and a side wall of the insulating layer to expose a portion of the substrate between the first pixel and the second pixel. The emission layer may contact the substrate via the trench. A portion of the emission layer may directly contact the substrate, i. e., be in surface contact with the substrate.

The second anode electrode may be disposed at a closer position to the substrate than the first anode electrode. In a direction perpendicular to a cross sectional direction, the second anode electrode may be disposed closer to the substrate than the first anode electrode. A portion of the cathode electrode disposed on the second anode electrode may be disposed at a closer height to the substrate than a portion of the cathode electrode disposed on the first anode electrode. In other words, a distance between the portion of the cathode electrode disposed on the second anode electrode to the substrate in a light emitting direction may be smaller than the respective distance of the portion of the cathode electrode disposed on the first anode electrode.

The cathode electrode may have an inclined surface at the side wall of the protrusion with respect to a horizontal surface of the substrate with an inclination angle θ in a range of 40 degrees to 80 degrees, preferably in the range of 50 degrees to 75 degrees.

In addition, the light emitting display device can have a structure in which almost all of the lights emitted from the emission layer can be extracted to the outside without being trapped and extinguished inside of the device, thereby providing a bottom emission type light emitting display device with maximized light extraction efficiency. The light emitting display device can also provide a bottom emission type light emitting display device minimizing non-emission areas and improve light extraction efficiency by arranging micro mirrors (or reflectors) without using a bank covering the circumferences of the pixel electrode. The light emitting display device can additionally have unit pixel configured with a red pixel, a green pixel, a blue pixel and a white pixel to improve the luminance. Further, the light emitting display device can be provided with enhanced luminance and improved light extraction efficiency by selectively removing the planarization layer which can cause a degradation in light extraction efficiency at the white pixel.

Also, the light emitting display device can have a structure in which a trench is placed around the white pixel, so the emission layer can be separated at the boundary of the white pixel. Accordingly, a bottom emission type light emitting display device with improved color purity can be provided by blocking and/or eliminating lateral leakage current generated at the white pixel due to connection of the emission layer.

By extracting light generated from the emission layer to the outside, which would otherwise be trapped inside the device and disappear due to total reflection the light extracting efficiency of the bottom emission type light emitting display device may be maximized. By arranging the micro mirror structure on the edge of the light emitting area to maximize the area of the light emitting area, the luminance maintenance factor and light extraction efficiency of the bottom emission type light emitting display device may be improved. Having a white pixel without color filter allocated to the white pixel, the light loss due to a planarization layer in the white pixel may be minimized.

The effects can be obtained from the present disclosure are not limited to the effects mentioned above, and other effects are not mentioned can be clearly understood by those skilled in the art to which this disclosure belongs from the description above.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is a diagram illustrating a schematic structure of a light emitting display device according to the present disclosure.
FIG. 2 is a circuit diagram illustrating a structure of one pixel included in the light emitting display device according to an example of the present disclosure.
FIG. 3 is a plan view illustrating an arrangement structure of the pixels disposed in the light emitting display device according to an example of the present disclosure.
FIG. 4 is an enlarged cross-sectional view along to cutting line I-I' in FIG. 3, for illustrating the structure of a light emitting display device according to an example of the present disclosure.
FIG. 5 is an enlarged cross-sectional view along to cutting line II-II' in FIG. 3, for illustrating light paths in a light emitting display device according to an example of the present disclosure.
FIG. 6 is an enlarged cross-sectional view, along line III-III' of FIG. 3, illustrating light paths in a light emitting display device according to a first embodiment of the present disclosure.
FIG. 7 is an enlarged cross-sectional view, along line III-III' of FIG. 3, illustrating a structure of a light emitting display device according to a second embodiment of the present disclosure.

### DETAILED DESCRIPTION OF THE EMBODIMENTS

Advantages and features of the present disclosure, and implementation methods thereof will be clarified through following embodiments described with reference to the accompanying drawings. The present disclosure can, however, be embodied in different forms and should not be construed as limited to the embodiments set forth herein. Rather, these example embodiments are provided so this disclosure can be sufficiently thorough and complete to assist those skilled in the art to fully understand the scope of the present disclosure. Further, the protected scope of the present disclosure is defined by claims.

The shapes, sizes, ratios, angles, numbers, and the like, which are illustrated in the drawings in order to describe various example embodiments of the present disclosure, are merely given by way of example. Therefore, the present disclosure is not limited to the illustrated details. Like reference numerals refer to like elements throughout the specification unless otherwise specified. In the following description, where the detailed description of the relevant known function or configuration can unnecessarily obscure an important point of the present disclosure, a detailed description of such known function of configuration can be omitted.

Reference will now be made in detail to the exemplary embodiments of the present disclosure, examples of which are illustrated in the accompanying drawings. Wherever possible, the same reference numbers will be used throughout the drawings to refer to the same or like parts. In the specification, it should be noted like reference numerals already used to denote like elements in other drawings are used for elements wherever possible. In the following description, when a function and a configuration known to those skilled in the art are irrelevant to a particular configuration of the present disclosure, their detailed descriptions will be omitted. The terms described in the specification should be understood as follows.

In the present specification, where the terms "comprise," "have," "include," and the like are used, one or more other elements can be added unless the term, such as "only," is used. An element described in the singular form is intended to include a plurality of elements, and vice versa, unless the context clearly indicates otherwise. Also, in construing an element, the element is construed as including an error or tolerance range even where no explicit description of such an error or tolerance range is provided.

Further, in the description of the various embodiments of the present disclosure, where positional relationships are described, for example, where the positional relationship between two parts is described using "on," "over," "under," "above," "below," "beside," "next," or the like, one or more other parts can be located between the two parts unless a more limiting term, such as "immediate(ly)," "direct(ly)," or "close(ly)" is used. For example, where an element or layer is disposed "on" another element or layer, a third layer or element can be interposed therebetween. Also, if a first element is described as positioned "on" a second element, it does not necessarily mean the first element is positioned above the second element in the figure. In addition, the upper part and the lower part of an object concerned can be changed depending on the orientation of the object. Consequently, where a first element is described as positioned "on" a second element, the first element can be positioned "below" the second element or "above" the second element in the figure or in an actual configuration, depending on the orientation of the object. Further, in describing a temporal relationship, when the temporal order is described as, for example, "after," "subsequent," "next," or "before," a case which is not continuous can be included unless a more limiting term, such as "just," "immediate(ly)," or "direct(ly)," is used.

In addition, it will be understood that, although the terms "first," "second," and the like can be used herein to describe various elements, these elements should not be limited by these terms as they are not used to define a particular order. These terms are used only to distinguish one element from another. For example, a first element could be termed a second element, and, similarly, a second element could be termed a first element, without departing from the scope of the present disclosure.

Further, in describing various elements in the present disclosure, terms such as first, second, A, B, (a), and (b) may be used. These terms are used merely to distinguish one element from another, and not to define a particular nature, order, sequence, or number of the elements. Where an element is described as being "linked", "coupled," or "connected" to another element, that element may be directly or indirectly connected to that other element unless otherwise specified. It is to be understood that additional element or elements may be "interposed" between the two elements which are described as "linked," "connected," or "coupled" to each other.

Still further, it should be understood the term "at least one" should be understood as including any and all combinations of one or more of the associated listed items. For example, the meaning of "at least one of a first element, a second element, and a third element" encompasses the combination of all three listed elements, combinations of any two of the three elements, as well as each individual element, the first element, the second element, and the third element.

Features of various embodiments of the present disclosure may be partially or overall coupled to or combined with each other, and may be variously inter-operated with each other and driven technically as those skilled in the art can sufficiently understand. The embodiments of the present disclosure may be carried out independently from each other, or may be carried out together in a co-dependent relationship. Hereinafter, an example of a display apparatus according to the present disclosure will be described in detail with reference to the attached drawings. Wherever possible, the same reference numbers will be used throughout the drawings to refer to the same or like parts. Hereinafter, referring to figures, the present disclosure will be explained.

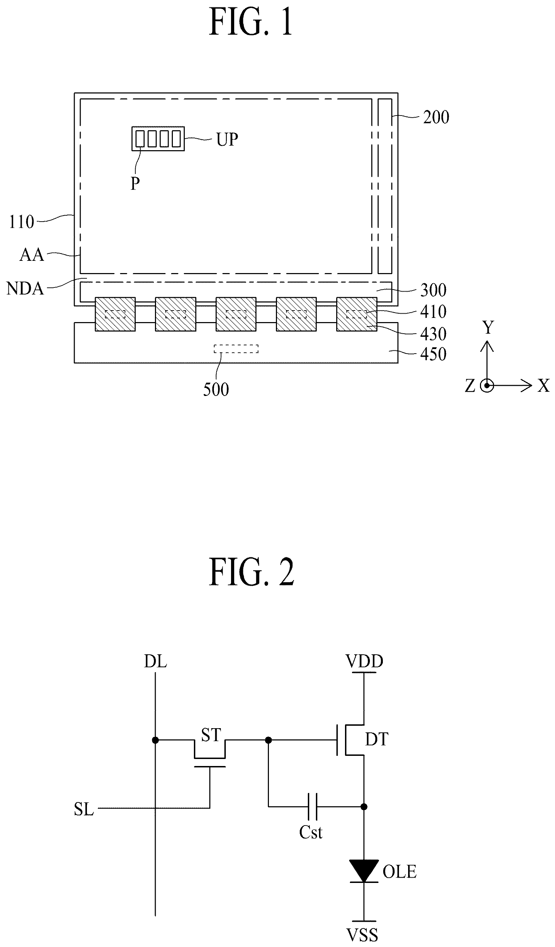

FIG. 1 is a diagram illustrating a schematic structure of a light emitting display device according to the present disclosure. In FIG. 1, the X-axis refers to the (left-right) direction parallel to example scan lines, the Y-axis refers to the (up-down) direction of example data lines, and the Z-axis refers to the height (or thickness) direction of the display device. Referring to FIG. 1, the light emitting display device includes a substrate 110, a gate (or scan) driver 200, a pad portion 300, a source driving IC (Integrated Circuit) 410, a flexible circuit film 430, a circuit board 450, and a timing controller 500.

The substrate 110 may include an electrical insulating material or a flexible material. The substrate 110 may be made of a glass, a metal, or a plastic, but it is not limited thereto. When the light emitting display device is a flexible display, the substrate 110 may be made of the flexible material such as plastic. For example, the substrate 110 may include a transparent polyimide material. The substrate 110 may also include a display area AA and a non-display area NDA.

The display area AA, which is an area for representing the video images, may be defined as the majority middle area of the substrate 110, but it is not limited thereto. In the display area AA, a plurality of scan lines (or gate lines), a plurality of data lines, and a plurality of unit pixels UP may be formed or disposed with the unit pixels UP are arrayed in a matrix manner. Each of unit pixels UP can include a plurality of pixels P, and each of the pixels P can contact at least one respective scan line and data line.

Also, the non-display area NDA, which is an area not displaying video images, may be defined at the circumference areas of the substrate 110 surrounding all or some of the display area AA. In the non-display area NDA, the gate driver 200 and the pad portion 300 may be formed or disposed. The gate driver 200 may supply the scan (or gate) signals to the scan lines according to the gate control signal input through the pad portion 300 from the timing controller 500. Similarly, the gate driver 200 may be formed at the non-display area NDA at any one outside of the display area AA on the substrate 110, as a GIP (Gate driver In Panel) type. The term "GIP type" means the gate driver 200 is directly formed on the substrate 110. For example, the gate driver 200 may be configured as a shift resistor with the term "GIP type" referring to a structure in which transistors for the shift resistor of the gate driver 200 are directly formed on the substrate 110.

Also, the pad portion 300 may supply data signals to data lines according to a data control signal input from the timing control unit 500. The pad portion 300 may be formed as a driving chip and mounted the flexible circuit film 430, and the flexible circuit film 430 may be attached to the non-display area NDA of one edge of the display area AA of the substrate 110.

In addition, the source driving IC 410 may receive the digital video data and the source control signal from the timing controller 500, convert the digital video data into the analog data voltages according to the source control signal, and then supply the analog data voltages to the data lines. When the source driving IC 410 is made as a chip type, the source driving IC 410 can be installed on the flexible circuit film 430 as a COF (chip on film) or COP (chip on plastic) type.

Further, the flexible circuit film 430 can include a plurality of first link lines connecting the pad portion 300 to the source driving IC 410, and a plurality of second link lines connecting the pad portion 300 to the circuit board 450. In various examples, the flexible circuit film 430 can be attached on the pad portion 300 using an anisotropic conducting film so the pad portion 300 can be connected to the first link lines of the flexible circuit film 430.

Also, the circuit board 450 can be attached to the flexible circuit film 430 and can include a plurality of circuits implemented as the driving chips. For example, the circuit board 450 can be a printed circuit board or a flexible printed circuit board. The circuit board 450 can also be a printed circuit board or a flexible printed circuit board.

In operation, the timing controller 500 can receive the digital video data and the timing signal from an external system board through the line cables of the circuit board 450. Next, the timing controller 500 can generate a gate control signal for controlling the operation timing of the gate driver 200 and a source control signal for controlling the source driving IC 410, based on the timing signal. Then, the timing controller 500 can supply the gate control signal to the gate driver 200 and supply the source control signal to the source driving IC 410. Depending on the product types, the timing controller 500 can be formed as one chip with the source driving IC 410 and mounted on the substrate 110.

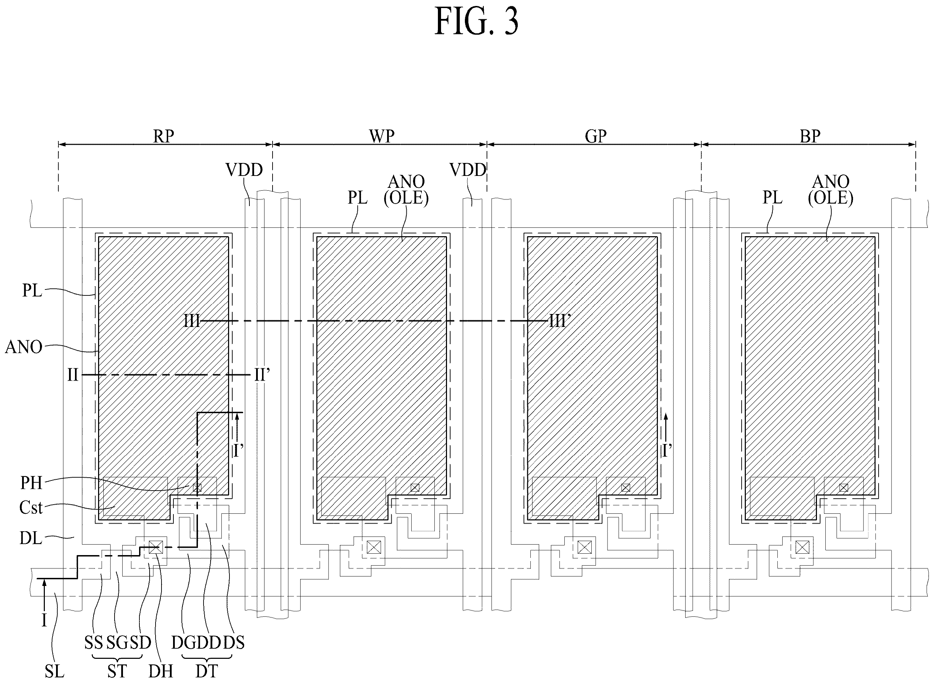

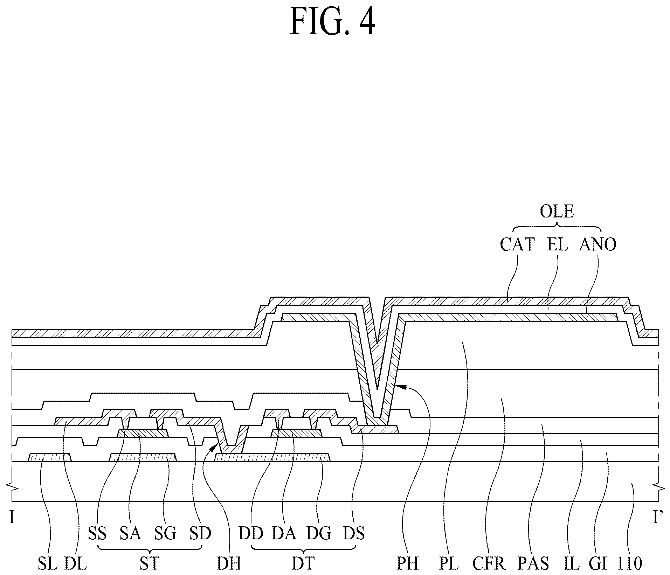

Next, referring to FIGS. 2 to 4, an embodiment of the present disclosure will be explained. FIG. 2 is a circuit diagram illustrating a structure of one pixel included in a pixel area of the light emitting display device. FIG. 3 is a plan view illustrating an arrangement structure of pixels disposed in respective pixel areas in the light emitting display device. FIG. 4 is an enlarged cross-sectional view along to cutting line I-I' in FIG. 3, for illustrating the structure of a light emitting display device.

Referring to FIGS. 2 to 4, an example light emitting display device includes a plurality of unit pixels UP. One unit pixel UP, in turn, can include three pixels P or four pixels P. For example, one unit pixel UP can include a red pixel, a green pixel, and a blue pixel. For another example, as shown in FIG. 3, one unit pixel UP can include a red pixel RP, a white pixel WP, a green pixel GP, and a blue pixel BP.

In the following description, the term "one pixel" of the light emitting display device can be any one of a red pixel RP, a white pixel WP, a green pixel GP, and a blue pixel BP with the one pixel disposed at an intersection of a scan line SL, a data line DL, and a driving current line VDD. As shown in FIG. 2, any one pixel of the light emitting display device can include a switching thin film transistor ST, a driving thin film transistor DT, a light emitting diode OLE, and a capacitor Cst. The driving current line VDD can be supplied with a high-level voltage for driving the light emitting diode OLE. As used below in reference to the drawings, a red pixel RP can include a red light emitting diode OLER, a white pixel WP can include a white light emitting diode OLEW, a green pixel GP can include a green light emitting diode OLEG, and a blue pixel BP can include a blue light emitting diode OLEB. Similarly, for anode electrodes ANO, a red pixel RP can include a red anode electrode ANOR, a white pixel WP can include a white anode electrode ANOW, a green pixel GP can include a green anode electrode ANOG, and a blue pixel BP can include a blue anode electrode ANOB.

Next, in the following description referring to FIG. 3, a pixel P can have a structure in which a data line DL is disposed at the left side of the pixel P, and a driving current line VDD is disposed at the right side of the pixel P. However, pixels are not limited thereto, and various structures can be acceptable. For example, with four pixels P as a unit pixel UP, a driving current line VDD can be arranged at the left and right sides of one unit pixel UP, and a reference line can be arranged between the white pixel WP and a green pixel GP. In addition, each data line DL can be placed at the left side of each pixel P.

Further, the switching thin film transistor ST shown in FIG. 2 can be disposed at a location where the scan line SL and the data line DL intersect, and can include a gate electrode SG, a semiconductor layer SA, a source electrode SS, and a drain electrode SD. The gate electrode SG can be connected to the scan line SL, the source electrode SS can be connected to the data line DL, and the drain electrode SD can be connected to the driving thin film transistor DT. The semiconductor layer SA of the switching thin film transistor ST can be disposed on a gate insulating layer GI overlapping the gate electrode SG, and the portion of the semiconductor layer SA overlapping the gate electrode SG can be defined as a channel region.

Also, an intermediate insulating layer IL can be deposited on the semiconductor layer SA with the source electrode SS and the drain electrode SD formed on the intermediate insulating layer IL. Further, the source electrode SS can be connected to one side of the semiconductor layer SA via one contact hole formed at the intermediate insulating layer IL, and the drain electrode SD can be connected to another side of the semiconductor layer SA via another contact dhole formed at the intermediate insulating layer IL. The switching thin film transistor ST can be used to select a pixel P to be driven by applying a data signal to the driving thin film transistor DT.

In addition, the driving thin film transistor DT can drive the light emitting diode OLE of the pixel selected by the switching thin film transistor ST. Also, the driving thin film transistor DT can include a gate electrode DG, a semiconductor layer DA, a source electrode DS and a drain electrode DD. Further, the gate electrode DG of the driving thin film transistor DT can be connected to the drain electrode DD of the switching thin film transistor ST. For example, the gate electrode DG of the driving thin film transistor DT can be connected to the drain electrode DD of the switching thin film transistor ST via a drain contact hole DH penetrating the gate insulating layer GI covering the gate electrode DG. The drain electrode DD can be connected to the driving current line VDD, and the source electrode DS can be connected to an anode electrode ANO of the light emitting diode OLE. The capacitor Cst can be disposed between the gate electrode DG of the driving thin film transistor DT and the anode electrode ANO of the light emitting diode OLE.

Also, the intermediate insulating layer IL can be deposited on the semiconductor layer DA, and the source electrode DS and the drain electrode DD can be formed on the intermediate insulating layer IL. Also, the source electrode DS can be connected to one side of the semiconductor layer DA via one contact hole formed at the intermediate insulating layer IL while the drain electrode DD can be connected to another side of the semiconductor layer DA via another contact hole formed at the intermediate insulating layer IL.

Further, the driving thin film transistor DT can be disposed between the driving current line VDD and the light emitting diode OLE. The driving thin film transistor DT can control the amount of current flowing from the driving current line VDD to the light emitting diode OLE according to the magnitude of the voltage of the gate electrode DG of the driving thin film transistor DT connected to the drain electrode SD of the switching thin film transistor ST. As shown in FIG. 4, the drain electrode SD of the switching thin film transistor ST is electrically connected to the gate electrode DG of the driving thin film transistor DT through opening DH, which passes through the gate insulating layer GI and the intermediate insulating layer IL.

Next, the light emitting diode OLE can include an anode electrode ANO, an emission layer EL, and a cathode electrode CAT, and can emit lights in response to an electric current controlled by the driving thin film transistor DT. Since the amount of light emitted can be adjusted according to the current controlled by the driving thin film transistor DT, the brightness of the light emitting display device can be controlled. Also, the anode electrode ANO of the light emitting diode OLE can be connected to the source electrode DS of the driving thin film transistor DT, and the cathode electrode CAT can be connected to a low voltage line VSS to which a low potential voltage is applied. Thus, the light emitting diode OLE can be driven by the difference between a low-potential voltage and a high-potential voltage controlled by a driving thin film transistor DT.

In addition, a passivation layer PAS can be deposited on the surface of the substrate 110 having the thin film transistors ST and DT with the passivation layer PAS including an inorganic material such as silicon oxide (SiOx) or silicon nitride (SiNx). As used herein, the layers configuring the thin film transistors ST and DT on the substrate 110 can be called a 'driving element layer.' For example, from the metal layer for the scan line SL and the gate electrodes SG and DG to the passivation layer PAS covering the thin film transistors ST and DT can be defined as the driving element layer.

Further, a color filter CF can be formed on the passivation layer PAS and can disposed on each pixel P. In various examples, the color filter CF can include a red color filter CFR at the red pixel RP, a green color filter CFG at the green pixel GP, and a blue color filter CFB at the blue pixel BP while the white pixel WP has no color filter.

FIG. 4 shows the color filter CF (red color filter CFR in FIG. 4) is extended from the emission area (i.e., an area where an anode ANO, emission layer EL, and cathode CAT overlap) to the non-emission area (i.e., an area where no anode ANO overlaps with both an emission layer EL and cathode CAT). However, pixels are not limited thereto, and the color filter CF can be disposed as corresponding to the emission area only. Also, a planarization layer PL can be deposited on the color filter CF. The planarization layer PL can be a thin film for making the surface of the substrate 110 on which thin film transistors ST and DT are formed flat. To make even the height difference, the planarization layer PL can be formed of an organic material.

Further, a pixel contact hole PH for exposing a portion of the source electrode DS of the driving thin film transistor DT can be formed as penetrating the passivation layer PAS, the color filter CF, and the planarization layer PL. Also, an anode electrode ANO can be formed on the planarization layer PL with the anode electrode ANO connected to the source electrode DS of the driving thin film transistor DT via the pixel contact hole PH.

As is also shown in FIG. 4, the planarization layer PL can have a step difference. For example, the planarization layer PL can be patterned using the anode electrode ANO as a mask, so the planarization layer PL can have a structure in which a portion of the planarization layer PL protrudes upward, and the anode electrode ANO is formed on the protruded portion of the planarization layer PL. FIG. 4 shows the protrusion portion of the planarization layer PL covers the pixel contact hole PH. However, it is not limited thereto as, in various examples, the protrusion portion of the planarization layer PL may not cover the pixel contact hole PH. In such a situation, the pixel contact hole PH and the area around the pixel contact hole PH can be included in the non-emission area. For another example, instead of patterning the planarization layer PL, a first planarization layer covering entire surface of the substrate 110 can be deposited, and then a second planarization layer having an island shape protruding upward from the first planarization layer can be formed.

Also, the anode electrode ANO can have different material depending on the emission type of the light emitting diode OLE. For instance, for a bottom emission type in which the light emitting diode OLE emits to the substrate 110, the anode electrode ANO can be formed of a transparent conductive material. In contrast, for a top emission type in which the light emitting diode OLE emits upward opposing the substrate 110, the anode electrode ANO can be formed of a metal material having excellent light reflectance. In this top emission type situation, the anode electrode ANO can have a structure in which a transparent conductive layer and a metal layer are stacked.

Also, for the bottom emission type situation, the anode electrode ANO can be made of a transparent conductive material (TCO) or semi-transparent conductive material. For instance, the anode electrode ANO can be made of a transparent conductive material such as indium tin oxide (ITO), indium zinc oxide (IZO), or indium zinc tin oxide (IZTO). Otherwise, the anode electrode ANO can be made of a semi-transparent layer of magnesium (Mg), silver (Ag), or an alloy of magnesium (Mg) and silver (Ag) with a thickness of less than 100nm. The example anode electrode ANO can be called as a first electrode or a transparent electrode.

Further, an emission layer EL can be deposited on the anode electrode ANO. The emission layer EL can be deposited in the form of a continuously connected thin layer over the entire surface of the substrate 110. The emission layer EL can also have a stacked structure with several functional layers. For example, the emission layer EL can include a hole functional layer, an organic light emitting layer, and an electron functional layer. The hole functional layer and the electron functional layer can be deposited in the form of continuously connected layers over the entire surface of the substrate 110. The organic light emitting layer can also be deposited in the form of a continuously connected layer over the entire surface of the substrate 110 between the hole function layer and the electron functional layer. However, the present disclosure is not limited thereto, and the organic light emitting layer can be separately deposited to be arranged as corresponding to each emission area of the pixel P.

Further, the emission layer EL can include at least two emission parts for generating white light. For example, the emission layer EL can include a tandem structure in which a first emission part and a second emission part are vertically stacked for generating white light by mixing the first light from the first emission part and the second light from the second emission part. However, the present disclosure is not limited thereto, and the emission layer EL can include three emission parts or four emission parts vertically stacked to form the tandem structure.

Next, a cathode electrode CAT can be deposited on the emission layer EL with the cathode electrode CAT disposed as a thin layer shape continuously deposited on the entire surface of the substrate 110. Thus, the stacked structure of the anode electrode ANO, the emission layer EL, and the cathode electrode CAT can constitute the light emitting diode OLE. Further, the cathode electrode CAT, which can be called as a second electrode, reflection electrode, or counter electrode, can be made of a metal material having excellent light reflectance. For example, the cathode electrode CAT may be formed of a metal material with excellent light reflectance with a thickness of at least 2,000Å to 3,000Å (200nm to 300nm). Here, the metal material having excellent light reflectance may include aluminum (Al), magnesium (Mg), calcium (Ca), silver (Ag) ,or alloy thereof (i.e., aluminum-magnesium alloy (AlMg)). In another example, the cathode electrode CAT may include a stack of aluminum and titanium (Ti/Al/Ti), a stack of aluminum and indium tin oxide (ITO/Al/ITO), a silver alloy, or a stack of silver alloy and indium tin oxide (ITO/Ag alloy/ITO). Here, a silver alloy can be an alloy of silver (Ag), palladium (Pd) and copper (Cu).

The stacked structure of the anode electrode ANO, the emission layer EL and the cathode electrode CAT can constitute the light emitting diode OLE. Also, the light emitting display device according to the present disclosure can have a structure in which each of light emitting diode OLE is disposed on the planarization layer PL patterned with protruding island shape within the pixel P. From the planarization layer PL deposited on the driving element layer to the cathode electrode CAT of the light emitting diode OLE can be called a 'light emitting element layer.'

In detail, within each pixel P, the planarization layer PL can be deposited over entire surface of the substrate 110, and can include a protrusion formed as an island shape with a predetermined thickness. The anode electrode ANO can be formed within the top surface of the protrusion. The emission layer EL can be deposited to cover the upper surface of the planarization layer PL having the step difference and the top surface of the anode electrode ANO. The cathode electrode CAT can be also deposited with the same profile as the emission layer EL. As a result, the cathode electrode CAT can have a cap shape, '∩', i.e., concave downwards or convex upwards. Since the cathode electrode CAT can be made of a metal material with excellent light reflectance, the cathode electrode CAT can have a structure in which the cap shaped micro mirrors are formed around the protrusion of the planarization layer PL.

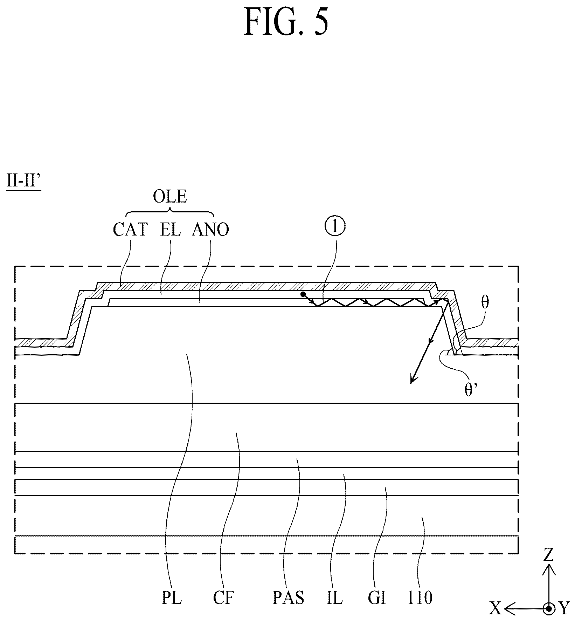

In the situation of a bottom emission type, there can be a disadvantage in the area ratio of the aperture area to the pixel area can be relatively smaller than top emission type, due to the thin film transistor ST and DT, capacitor Cst, and lines SL, DL, and VDD. However, the light emitting display device according to the present disclosure can provide a structure equipped with a micro mirror so light generated from the emission layer EL can be provided toward the substrate 110 placed underneath without loss even though the aperture area is small. Hereinafter, referring to FIG. 5, the mechanism for enhancing the light extraction efficiency by the micro mirror will be explained. FIG. 5 is an enlarged cross-sectional view along to cutting line II-II' in FIG. 3, for illustrating light paths in a light emitting display device according to an example of the present disclosure.

Referring to FIG. 5, the optical path ① for light emitted from the emission layer EL at the edge region of the anode electrode ANO is described. Light emitted from the emission layer EL can be transmitted as a spherical wave, i.e., light can be emitted in all directions 360 degrees on the cross-sectional view. Also, light emitted to the top direction can be reflected by the cathode electrode CAT and travel downward such that most of the light generated from the emission layer EL can be radiated in a 180-degree downward direction. This light can be incident into the anode electrode ANO, and since the anode electrode ANO can be made of a transparent conductive material, 60% to 70% of the light can pass through the anode electrode ANO, can pass through the color filter CF placed underneath, and can be emitted outside the substate 110.

Further, the anode electrode ANO can be a transparent conductive material with a refractive index of 2.0 to 2.3. Assuming the upper surface of the anode electrode ANO is in contact with the emission layer EL, the bottom surface of the anode electrode ANO is in contact with the planarization layer PL, and the emission layer EL and the planarization layer PL have a refractive index of 1.3 to 1.5, a structure can be formed in which an anode electrode ANO with a high refractive index is interposed between two low refractive layers. Therefore, among the light incident into the anode electrode ANO, 30% to 40% corresponding to the total reflection condition can be propagated in the horizontal direction (X-axis direction) inside the anode electrode ANO.

In addition, the refractive index of the emission layer EL can be similar to the refractive index of the anode electrode ANO. In this situation, among the light emitted from the emission layer EL, the light totally reflected at the interface between the anode electrode ANO and the planarization layer PL can be trapped between the cathode electrode CAT and the planarization layer PL, and so such light can propagate in the horizontal direction (X-axis direction). The light propagating horizontally within the anode electrode ANO, or between the cathode electrode CAT and the planarization layer PL, can then be emitted from the end of the anode electrode ANO and be reflected by the cathode electrode CAT having the micro mirror structure to be directed downward. When there is no micro mirror structure formed by the protrusion of the planarization layer PL, the lights can be propagated horizontally and thus be extinguished. However, according to this structure, the lights can be extracted downward by the micro mirror, thereby improving the light extraction efficiency.

Here, in order to ensure the lights reflected by the cathode electrode CAT having a micro mirror structure can be emitted to the downward direction properly, it is useful to adjust the angle of the inclination of the cathode electrode CAT deposited on the etched side where the step of the planarization layer PL is formed. For example, the angle θ of the inclined surface of the cathode electrode CAT with respect to the horizontal surface of the substrate 110 can advantageously be in the range of 40 degrees to 80 degrees. More advantageously, the inclination angle θ can be in the range of 50 degrees to 75 degrees. Since the cathode electrode CAT is deposited along the step shape of the planarization layer PL, the inclination angle θ of the cathode electrode CAT can be substantially equal to the side wall inclination angle θ' of the protrusion at the planarization layer PL. Therefore, it is more advantageous to form the inclination angle θ' of the side wall of the protrusion to be 50 degrees to 75 degrees.

In addition, the light emitting display device according to the present disclosure can include a cathode electrode CAT having a micro-mirror structure due to a planarization layer PL having an island shaped protrusion. Extracting light generated from the emission layer EL using the micro-mirror, which would otherwise be lost without the micro-mirror structure, the light extraction efficiency can be improved.

In the above descriptions, the structural feature of one pixel in the light emitting display device according to the present disclosure have been explained. Hereinafter, it will be explained a micro-mirror structure formed at a white pixel in the light emitting display device in which a red pixel, a white pixel, a green pixel, and a blue pixel configure one unit pixel. In the following descriptions, the same descriptions for the driving element layer will not be duplicated. In addition, the configuration of the driving element layer is not limited to the structure described in FIGS. 2 to 4. For example, the configuration of the thin film transistors ST and DT can have a top gate structure, a bottom gate structure, or a double gate structure. Further, the thin film transistors ST and DT can include an oxide semiconductor material. For example, the material for the semiconductor layer SA and DA can include a metal oxide semiconductor material such as the indium gallium zinc oxide (IGZO). However, it is not limited thereto, and the semiconductor layer SA and DA can include an amorphous silicon, a poly-crystalline silicon, or a low temperature poly silicon (LTPS). In addition, the arrangement structure of the signal lines including the scan line SL, the data line DL, and the driving current line VDD can also be varied. Further, other signal lines such as the reference line can be included. In the following descriptions, drawing symbols are shown in the drawings but not explained refer to the descriptions of the same drawing symbols in FIGS. 2 to 4.

### <First Embodiment>

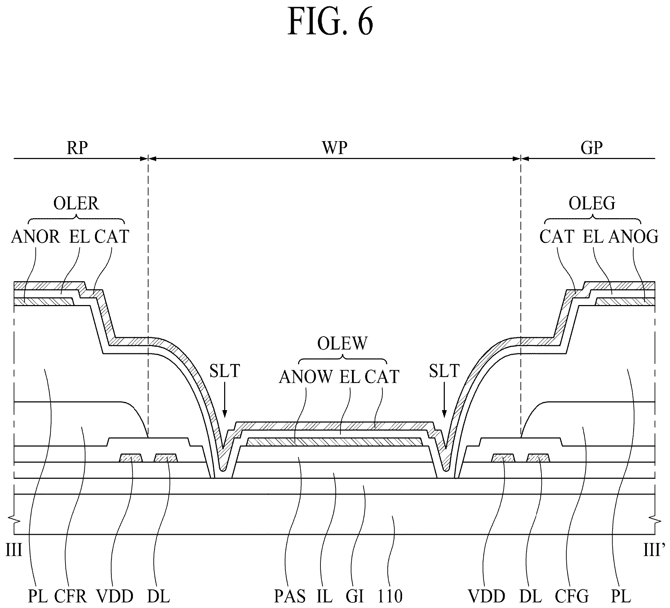

Hereinafter, referring to FIG. 6, a structure of a light emitting display device according to a first embodiment of the present disclosure will be described. FIG. 6 is an enlarged cross-sectional view, along line III-III' of FIG. 3, illustrating light paths in a light emitting display device according to a first embodiment of the present disclosure.

The light emitting display device according to the present disclosure can include a plurality of unit pixels UP. Each of unit pixel UP can be configured with a red pixel RP, a white pixel WP, a green pixel GP, and a blue pixel BP. However, the example light emitting display device can exclude a color filter at the white pixel WP. Therefore, the anode electrode of the white pixel WP can be disposed at lower position than the other anode electrodes which are disposed at other pixels having color filters. Further, under the anode electrodes of the pixels having the color filter, the planarization layer, the color filter, the passivation layer, the intermediate insulating layer, and the gate insulating layer are sequentially stacked in a reversed order. At the white pixel WP having no color filter, the planarization layer can be removed for preventing light loss due to the total reflection by the planarization layer. Without planarization, the white pixel WP can have a micro-mirror structure by patterning the passivation layer and the intermediate insulating layer.

Referring to FIG. 6, a gate insulating layer GI can be deposited on the entire surface of a substrate 110, an intermediate insulating layer IL can be deposited on the gate insulating layer GI, and a data line DL and a driving current line VDD can then be formed on the intermediate insulating layer IL. A pixel can be defined at the area between the data line DL and the driving current line VDD. A passivation layer PAS can then be deposited on the entire surface of the intermediate insulating layer IL having the data line DL and the driving current line VDD.

In the red pixel RP, a red color filter CFR can be formed on the passivation layer PAS, and a planarization layer PL can be deposited on the red color filter CFR with the planarization layer PL patterned to have a protrusion at the middle portion of the red pixel RP. Similarly, in the green pixel GP, a green color filter CFG can be formed on the passivation layer PAS, and the planarization layer PL can be deposited on the green color filter CFG with the planarization layer PL patterned to have a protrusion at the middle portion of the green pixel GP. Further, in the blue pixel BP, a blue color filter CFB can be formed on the passivation layer PAS, and the planarization layer PL can be deposited on the blue color filter CFB with the planarization layer PL patterned to have a protrusion at the middle portion of the blue pixel BP. In contrast, the planarization layer PL is not disposed at the white pixel WP. This can be accomplished by depositing the planarization layer PL over the entire surface of the substrate 110, whereafter the planarization layer PL can be patterned so protrusions are formed at each of the middle portions of the red pixel RP, the green pixel GP, and the blue pixel BP while the planarization layer PL is removed at the middle portion of the white pixel WP.

Also, at the red pixel RP, a first anode electrode ANOR can be formed on an upper surface of the protrusion of the planarization layer PL. An emission layer EL can be deposited on the first (red) anode electrode ANOR and the planarization layer PL, and a cathode electrode CAT can be deposited on the emission layer EL. As the cathode electrode CAT can be deposited along the cross-sectional profile of the planarization layer PL having the step difference, the cathode electrode CAT can have a '∩' shape in the cross-sectional view. Therefore, a micro-mirror structure can be formed at the circumference of the red pixel RP.

Turning to the white pixel WP, a second anode electrode ANOW can be formed on the passivation layer PAS, and a slit-shaped trench SLT can be formed by etching the passivation layer PAS exposed at the edge of the second anode electrode ANOW, and the intermediate insulating layer IL under the passivation layer PAS. As a result, in the white pixel WP, the passivation layer PAS and the intermediate insulating layer IL can have an island shape protruded on the gate insulating layer GI corresponding to the protrusion of the planarization layer PL disposed under the first anode electrode ANOR in the red pixel RP.

Next, the emission layer EL can be deposited on the second (white) anode electrode ANOW, and the cathode electrode CAT can be deposited on the emission layer EL. The emission layer EL and the cathode electrode CAT can be deposited along the cross-sectional profile of the passivation layer PAS and the intermediate insulating layer IL. Therefore, the cathode electrode CAT can have a '∩' shape in the cross-sectional view. Accordingly, a micro-mirror structure can be formed at the circumference of the white pixel WP.

Since a planarization layer PL is not placed on the white pixel WP, light loss due to total reflection between anode electrode and the planarization layer as explained in FIG. 5 can be minimized. Further, the cathode electrode CAT can have a micro-mirror structure due to a slit-shaped trench SLT in which the passivation layer PAS and the intermediate insulating layer IL are patterned in an isolated island shape on the gate insulating layer GI. Also, since the planarization layer PL is removed in the white pixel WP, the second anode electrode ANOW of the white pixel WP can be positioned at lower height than the first anode electrode ANOR of the red pixel RP. For example, the second anode electrode ANOW can be placed as being closer to the substrate 110 than the first anode electrode ANOR.

In addition, in the green pixel GP, a green color filter CFG can be formed on the passivation layer PAS, the planarization layer PL can be deposited on the green color filter CFG, and the planarization layer PL can be patterned to be protrude at the middle portion of the green pixel GP. Also, a third anode electrode ANOG can be formed on the upper surface of the protrusion of the planarization layer PL. Then, the emission layer EL can be deposited on the third anode electrode ANOG and the planarization layer PL, and the cathode electrode CAT can be deposited on the emission layer EL. As the cathode electrode CAT can be deposited along the cross-sectional profile of the planarization layer PL having the step difference, the cathode electrode CAT can have a '∩' shape in the cross-sectional view. Therefore, a micro-mirror structure can be formed at the circumference of the green pixel GP.

Referring to FIG. 6, the emission layer EL can be deposited along the cross-sectional profile (III-III' in FIG. 3) from the red pixel RP through the white pixel WP to the green pixel GP. Because of the step difference due to the trench SLT, the path of the emission layer EL can be longer in the red pixel RP, the blue pixel BP, and the green pixel GP than the white pixel WP. As a result, even though a lateral leakage current generated is transmitted to the white pixel WP from the red pixel RP, the path of the emission layer EL for transmitting the lateral leakage current from the red pixel RP to the white pixel WP is long enough to prevent the flow of lateral leakage current. Therefore, the lateral leakage current generated from the red pixel RP can not flow to (or affect) the white pixel WP. In more detail, the trench SLT can be formed between the side wall of the planarization layer PL at the red pixel RP and the side wall of the insulating layer (including the intermediate insulating layer IL and the passivation layer PAS) at the white pixel WP. Therefore, some portions of the gate insulating layer GI can be exposed from the trench SLT. However, the present disclosure is not limited thereto as the trench SLT can be formed by further etching the gate insulating layer GI, and some portions of the substrate 110 can be exposed to the trench STL.

In addition, the emission layer EL can be deposited as covering the first anode electrode ANOR, the second anode electrode ANOW, the planarization layer PL and the trench SLT. Therefore, the emission layer EL can contact the exposed portions of the gate insulating layer GI or the substrate 110 via the trench SLT formed between the red pixel RP and the white pixel WP. Between the green pixel GP and the white pixel WP, the trench SLT and the emission layer EL can be formed as the same structure.

Accordingly, the first embodiment of the present disclosure can provide a bottom emission type light emitting display device having an enhanced light extraction efficiency due to the micro-mirror structure. In addition, by selectively removing the planarization layer at the white pixel, the luminance degradation due to the planarization layer can be prevented, so the bottom emission type light emitting display device according to the first embodiment can have an improved luminance with the same power consumption. Furthermore, by arranging slit-shaped trench around the white pixel, the lateral leakage current can be prevented, so the bottom emission type light emitting display device according to the first embodiment can have an enhanced color purity.

### <Second Embodiment>

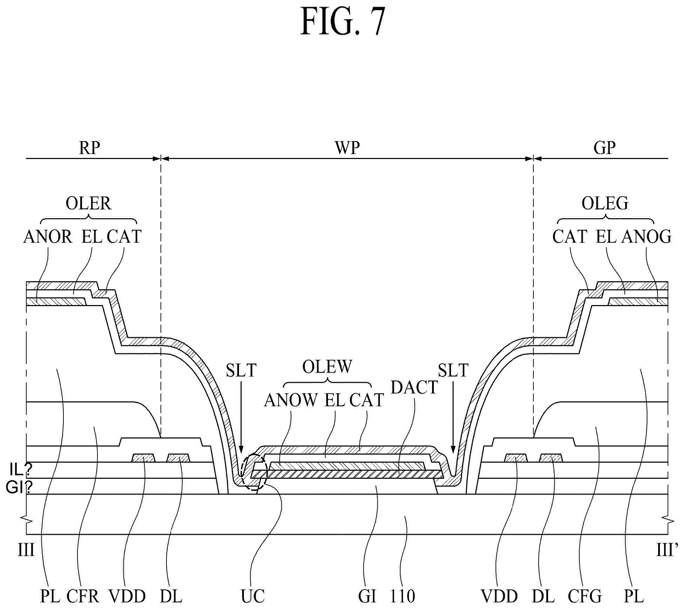

Hereinafter, referring to FIG. 7, a structure of a light emitting display device according to the second embodiment of the present disclosure will be explained. FIG. 7 is an enlarged cross-sectional view, along line III-III' of FIG. 3, illustrating a structure of a light emitting display device according to a second embodiment of the present disclosure.

A light emitting display device according to a second embodiment shown in FIG. 7 can have very similar structure with the display device according to the first embodiment. In particular, the red pixel RP, the green pixel GP, and the blue pixel BP having color filters can have the same structure as the first embodiment. However, the white pixel WP of the second embodiment can have different structure in the cross-sectional view from the first embodiment. In more detail, the light emitting display device according to the present disclosure can include a plurality of unit pixels UP with each unit pixel UP configured with a red pixel RP, a white pixel WP, a green pixel GP, and a blue pixel BP. As with the first embodiment, the light emitting display device according to the second embodiment can exclude a color filter at the white pixel WP. Also, as with the first embodiment, the bottom emission light emitting display device according to the second embodiment can have a structural feature in which the white pixel has the micro-mirror structure by removing the planarization layer.

Referring to FIG. 7, a gate insulating layer GI can be deposited on the entire surface of a substrate 110, an intermediate insulating layer IL can be deposited on the gate insulating layer GI, and a data line DL and a driving current line VDD can be formed on the intermediate insulating layer IL. A pixel can be defined at the area between the data line DL and the driving current line VDD. A passivation layer PAS can then be deposited on the entire surface of the intermediate insulating layer IL having the data line DL and the driving current line VDD.

As shown in FIG. 7, in the red pixel RP, a red color filter CFR can be formed on the passivation layer PAS, a planarization layer PL can be deposited on the red color filter CFR, and the planarization layer PL can be patterned to have a protrusion at the middle portion of the red pixel RP. Similarly, in the green pixel GP, a green color filter CFG can be formed on the passivation layer PAS, a planarization layer PL can be deposited on the green color filter CFG, and the planarization layer PL can be patterned to have a protrusion at the middle portion of the green pixel GP. In contrast, the planarization layer PL is not disposed at the white pixel WP. To accomplish this structure, the planarization layer PL can be deposited over the entire surface of the substrate 110, whereafter the planarization layer PL can be patterned so the protrusions are formed at each of the middle portions of the red pixel RP, the green pixel GP, and the blue pixel BP while the planarization layer PL is removed at the middle portion of the white pixel WP.

Also, at the red pixel RP, a first anode electrode ANOR can be formed on an upper surface of the protrusion of the planarization layer PL, an emission layer EL can be deposited on the first anode electrode ANOR and the planarization layer PL, and a cathode electrode CAT can be deposited on the emission layer EL. Similarly, at the green pixel RP, a third anode electrode ANOG can be formed on an upper surface of the protrusion of the planarization layer PL, an emission layer EL can be deposited on the third anode electrode ANOG and the planarization layer PL, and the cathode electrode CAT can be deposited on the emission layer EL. Similarly, at the blue pixel BP, a fourth anode electrode ANOB can be formed on an upper surface of the protrusion of the planarization layer PL, an emission layer EL can be deposited on the fourth anode electrode ANOB and the planarization layer PL, and the cathode electrode CAT can be deposited on the emission layer EL. As the cathode electrode CAT can be deposited along the cross-sectional profile of the planarization layer PL having the step difference, the cathode electrode CAT can have a '∩' shape in the cross-sectional view. Therefore, a micro-mirror structure can be formed at the circumference of the red pixel RP as well as the green pixel GP and the blue pixel BP.

In addition, in the white pixel WP, the gate insulating layer GI disposed on the substrate 110 can be patterned to form a trench SLT having a slit shape around the white pixel WP. That is, the gate insulating layer GI can have a protruded shape as an island within the white pixel WP. Such a feature can be accomplished using an etch stopper layer DACT formed on the gate insulating layer GI patterned in the island shape whereafter a anode electrode ANOW can be formed on the etch stopper layer DACT. As can be seen in FIG. 7, by over etching the gate insulating layer GI disposed under the etch stopper layer DACT, an under-cut area UC can be formed in which the gate insulating layer GI is removed to a certain distance below the etch stopper layer DACT. In this situation, it is preferable the etch stopper layer DACT can include a material having higher anti-etching property than the gate insulating layer GI for the etchant used for etching the gate insulating layer GI to form the slit-typed trench SLT.

For example, the gate insulating layer GI can made of an inorganic material such as silicon oxide or silicon nitride. In contrast, the etch stopper layer DACT can be made of a transparent conductive material such as indium-zinc-oxide (IZO) or a semiconductor material such as indium-gallium-zinc-oxide (IGZO) while the semiconductor layers SA and DA of the switching thin film transistor ST and the driving thin film transistor DT are formed on the gate insulating layer GI. In the situation where the semiconductor layers SA and DA are made of an oxide semiconductor material, i.e., indium-gallium-zinc-oxide, the etch stopper layer DACT can be selectively formed on the gate insulating layer GI in the white pixel WP.

Also, the etch stopper layer DACT can be disposed on the gate insulating layer GI having the slit typed trench SLT while the second anode electrode ANOW can be formed on the etch stopper layer DACT, have slightly narrower width than the etch stopper layer DACT, and be disposed at the middle portion of upper surface of the etch stopper layer DACT. As a result, in the white pixel WP, the gate insulating layer GI and the etch stopper layer DACT can have an island shape protruded on the substrate 110, which can correspond to the protrusion of the planarization layer PL disposed under the first anode electrode ANOR in the red pixel RP. Since the planarization layer PL is removed in the white pixel WP, the second anode electrode ANOW of the white pixel WP can be positioned at lower height than the first anode electrode ANOR of the red pixel RP. For example, the second anode electrode ANOW can be placed as being closer to the substrate 110 than the first anode electrode ANOR.

The emission layer EL can be deposited on the second anode electrode ANOW. The cathode electrode CAT can be deposited on the emission layer EL. The emission layer EL can be deposited along the cross sectional profile of the gate insulating layer GI, the etch stopper layer DACT and the second anode electrode ANOW having a step difference due to the protruded island shape. The emission layer EL can have a stepped shape corresponding to the cross sectional shape of the etch stopper layer DACT and the second anode electrode ANOW. As the emission layer EL includes an organic material, it has low step coverage property. As a result, the emission layer EL can have a disconnected shape because the emission layer EL may not be deposited along the under-cut shape where the under-cut area UC is formed. That is, the connectivity of the emission layer EL can be broken around the white pixel WP. Therefore, the lateral leakage current through the emission layer EL can be prevented from flowing into the white pixel WP.

Further, as is shown in FIG. 7, the trench SLT can be formed between the side wall of the planarization layer PL at the red pixel RP and the side wall of the gate insulating layer GI at the white pixel WP. Therefore, some portions of the substrate 110 can be exposed to the trench SLT.

Also, the emission layer EL can be deposited as covering the first anode electrode ANOR, the second anode electrode ANOW, the planarization layer PL, and the trench SLT. Therefore, the emission layer EL can contact the exposed portions of the gate insulating layer GI or the substrate 110 via the trench SLT formed between the red pixel RP and the white pixel WP. Between the green pixel GP and the white pixel WP, the trench SLT and the emission layer EL can be formed as the same structure.

Further, the cathode electrode CAT can be deposited on the emission layer EL with the cathode electrode CAT formed of a metal material, which has excellent step coverage property, i.e., an ability to remain continuous over stepped structures. Therefore, the cathode electrode CAT can be deposited without disconnection at the under-cut area UC. That is, the cathode electrode CAT can be continuously connected from the red pixel RP to the white pixel WP. As the emission layer EL can fill the under-cut area UC somewhat, so the step difference can be somewhat smoothed, so the cathode electrode CAT can be perfectly connected at the under-cut area UC. As the result, the cathode electrode CAT can have a concave, '∩'-, shape in the cross-sectional view covering the second anode electrode ANOW and the emission layer EL. Therefore, a micro-mirror structure can be formed at the circumference of the white pixel WP.

Also, since a planarization layer PL is not placed on the white pixel WP, light loss due to total reflection between anode electrode and the planarization layer as explained in FIG. 5 can be minimized. Further, the cathode electrode CAT can have a micro-mirror structure due to a slit-shaped trench SLT in which the passivation layer PAS and the intermediate insulating layer IL are patterned in an isolated island shape on the gate insulating layer GI.

As stated above, in the green pixel GP, a green color filter CFG can be formed on the passivation layer PAS, the planarization layer PL can be deposited on the green color filter CFG, and the planarization layer PL can be patterned to be protrude at the middle portion of the green pixel GP. Also, as stated above, a third anode electrode ANOG can be formed on the upper surface of the protrusion of the planarization layer PL, the emission layer EL can be deposited on the third anode electrode ANOG and the planarization layer PL, and the cathode electrode CAT can be deposited on the emission layer EL. As the cathode electrode CAT can be deposited along the cross-sectional profile of the planarization layer PL having the step difference, the cathode electrode CAT can have a concave, '∩'-, shape in the cross-sectional view. Therefore, a micro-mirror structure can be formed at the circumference of the green pixel GP.

As is also described above, for the first embodiment, by virtue of the under-cut area UC, the lateral leakage current flowing through the emission layer EL can be prevented by the slit shaped trench SLT. This structure can sufficiently block the lateral leakage current in a display device with a pixel density of 200 PPI (pixel per inch) or less, or in a display device with a relatively large distance between pixels. However, for the case of the ultra-high-density display device with a pixel density of 200PPI or higher, or the display device with relatively narrow space between pixels, it can be difficult to block the lateral leakage current using only the slit-shaped trench SLT. For these cases, applying the structure according to the second embodiment, the lateral leakage current can be effectively reduced or prevented.

For the light emitting display device having red pixels, green pixels, blue pixels, and white pixels, the white pixels can have the planarization layer without color filter. Therefore, due to the total reflection by the planarization layer, the luminance can be degraded. In order to solve this degraded luminance, the light emitting display device according to the present disclosure can have a structure in which the planarization layer is removed from the white pixel. Accordingly, by patterning the planarization layer to have protrusion and forming the light emitting diode on the protrusion, the micro-mirror structure can be formed around the pixel. With the micro-mirror structure, light can otherwise be lost due to total reflection inside the anode electrode or the light emitting layer can be directed / extracted downward. Therefore, the light extraction efficiency can be enhanced.

Also, in a light emitting display device having red pixels, green pixels, blue pixels, and white pixels, and having a micro-mirror structure by the protrusion of the planarization layer, a white color filter and planarization layer are not disposed in the white pixel. In order to form the micro-mirror structure in the white pixel, the insulating layer included in the driving element layer can be patterned to form a protrusion. By forming slit shaped trench around the white pixel, the insulating layer in the white pixel can have a protrusion. Further, by forming the light emitting diode on the insulating layer having the protrusion. Therefore, the white pixel can have a micro-mirror structure so the light extraction efficiency can be enhanced.

Furthermore, due to the slit-shaped trench SLT surrounding the white pixel WP, the lateral leakage current flowing through the emission layer EL can be minimized or blocked. For example, the emission layer deposited along the slit-shaped trench SLT can have enough long current path, so the lateral leakage current can be minimized. In addition, when forming the trench SLT, by further forming under-cut structure UC, the emission layer EL can be disconnected around the white pixel WP, so the lateral leakage current can be perfectly blocked.

Also, the slit-shaped trench SLT around the white pixel WP can have a closed curve shape completely surrounding the white pixel WP. For another example, as the lateral leakage current can mainly flow to left side or right side from the white pixel WP, in a cross-sectional view, the trench (SLT) can be disposed only at the left side of the white pixel WP and the right side of the white pixel WP, instead of surrounding the white pixel WP.

In still other examples, it is possible to etch the planarization layer PL such that any protrusion portion protrudes directly off a color filter CF while a portion of the planarization layer PL exposes a top portion of the color filter CF and a side portion of the planarization layer PL extends from a side of the color filter CF towards the slit-shaped trench SLT. In such examples, a portion of the emission layer EL can directly contact a top surface of the color filter CF as well as the top surface of the side portion of the planarization layer PL. In still other variations of this approach, the planarization layer PL can be etched such that any protrusion portion protrudes directly off a color filter CF while little or no residual portion of the planarization layer PL extends between the color filter CF and the slit-shaped trench SLT.

In yet another embodiment, the planarization layer PL can be eliminated so long as a top surface of the color filter CF can be adequately planarized and the sides be shaped at the incline angle θ discussed above, i.e., in the range of 40 degree to 80 degree, or in the range of 50 degree to 75 degree. Since the cathode electrode CAT would be deposited along the step shape of the color filter CF, the inclination angle θ of the cathode electrode CAT can be substantially equal to the side wall inclination angle θ' of the profile of the color filter CF.

In the embodiments described above, the explanation focuses on a bank-less structure in which bank is not formed. Here, bank refers to an insulating layer covers the edge of the anode electrode ANO and exposes the middle portions of the anode electrode ANO to define the emission area. The bank can also be called a 'pixel define layer.' The light emitting display device according to the present disclosure can exclude a bank. However, the present disclosure is not limited thereto, and a bank can be placed on the upper and lower sides of the pixel, i.e., the area where the driving elements are placed, while the left and right sides of the pixels can exclude the bank. Further, the structural features according to the present disclosure can be applied to a light emitting display having banks covering circumferential area of each pixel, and the present disclosure also provides a light emitting display device having the bank-less structure which is advantageous for low-power operation and maximizing the aperture ratio.

Thus, a light emitting display device includes: a substrate, an insulating layer, a planarization layer, a first anode electrode, a trench, a second anode electrode, an emission layer and a cathode electrode. The substrate has a first pixel and a second pixel. The insulating layer covers the first pixel and the second pixel on the substrate. The planarization layer is disposed on the insulating layer in the first pixel, and has a protrusion extruding upward. The first anode electrode is disposed on an upper surface of the protrusion of the planarization layer in the first pixel. The trench has a slit shape at a circumferential area of the second pixel by removing some portions of the insulating layer. The second anode electrode is disposed on the insulating layer in the second pixel. The emission layer is disposed on the first anode electrode and the second anode electrode. The cathode electrode is disposed on the emission layer.

In one example, the emission layer covers an upper surface of the planarization layer, a side wall of the protrusion and an upper surface of the first anode electrode in the first pixel. The emission layer covers the trench, an etched side wall of the insulating layer and an upper surface of the second anode electrode. The cathode electrode is in surface contact with the emission layer.

In another example, the light emitting display device further includes: an etch stopper layer between the second anode electrode and the insulating layer in the second pixel. In yet another example, the etch stopper layer includes a material having higher anti-etching property than the insulating layer against an etchant for patterning the insulating layer to form the trench. In still another example, the second anode electrode has shorter length than the etch stopper layer, and is disposed at a middle portion of the etch stopper layer. Also, the emission layer can have a step shape along the etch stopper layer and the second anode electrode in the second pixel.

In yet another example, the insulating layer has an under-cut area which has a smaller area than the etch stopper layer and is over etched under the insulating layer from the trench. In still another example, the emission layer is disconnected at the under-cut area between the first pixel and the second pixel. In various examples, the first pixel is selected one of a red pixel, a green pixel, and a blue pixel while the second pixel is a white pixel, which can be disposed at any one of between the red pixel and the green pixel, between the green pixel and the blue pixel, and between the blue pixel and the red pixel.

Also, in various examples, the light emitting display device further includes: a color filter layer between the planarization layer and the insulating layer; and a driving element layer between the planarization layer and the substrate. In one example, the color filter layer includes a red color filter, a green color filter, and a blue color filter. The first pixel, except the second pixel, includes any one of the red color filter, the green color filter, and the blue color filter. In another example, the driving element layer includes: a first driving element connected to the first anode electrode; and a second driving element connected to the second anode electrode.

In still other examples, each of the first driving element and the second driving element includes: a gate electrode on the substrate; a gate insulating layer covering the gate electrode; a semiconductor layer overlapping with the gate electrode on the gate insulating layer; an intermediate insulating layer covering the semiconductor layer; a source electrode connected to one side of the semiconductor layer and a drain electrode connected to another side of the semiconductor layer on the intermediate insulating layer; and a passivation layer covering the source electrode and the drain electrode.

In yet other examples, the planarization layer is disposed within the first pixel except the second pixel, a trench is disposed between a side wall of the planarization layer and a side wall of the insulating layer to expose some of the substrate between the first pixel and the second pixel, and an emission layer contacts the substrate via the trench. In yet more examples, the second anode electrode is disposed at a closer position to the substate than the first anode electrode, and a portion of the cathode electrode disposed on the second anode electrode is disposed at a closer height to the substrate than a portion of the cathode electrode disposed on the first anode electrode.

## Claims

1. A light emitting display device comprising:
a substrate (110) having a first pixel (RP, GP, BP) in a first pixel area and a second pixel in a second pixel area;
an insulating layer (IL, GI) covering the first pixel area and the second pixel area on the substrate (110);
a trench (SLT) having a slit shape between the first pixel area and the second pixel area that penetrates the insulating layer (IL, GI);
a planarization layer (PL) on the insulating layer (IL, GI) in the first pixel area, and having a protrusion extruding upward;
a first anode electrode (ANOR, ANOG, ANOB) on an upper surface of the protrusion of the planarization layer (PL) in the first pixel (RP, GP, BP);
a second anode electrode (ANOW) in the second pixel area and spaced apart from the planarization layer (PL);
an emission layer (EL) on the first anode electrode (ANOR, ANOG, ANOB) and the second anode electrode (ANOW); and
a cathode electrode (CAT) on the emission layer (EL) and disposed in the first pixel area and the second pixel area,
wherein the cathode electrode (CAT) forms a first concave mirror facing the substrate (110) directly above the first anode electrode (ANOR, ANOG, ANOB), and
wherein a portion of the cathode electrode (CAT) is disposed in the trench (SLT).

2. The light emitting display device according to claim 1, wherein the emission layer (EL) covers an upper surface of the planarization layer (PL), a side wall of the protrusion, and an upper surface of the first anode electrode (ANOR, ANOG, ANOB) in the first pixel (RP, GP, BP), and
wherein the emission layer (EL) covers the trench (SLT), an etched side wall of the insulating layer (IL, GI) and an upper surface of the second anode electrode (ANOW), and
wherein the cathode electrode (CAT) is in surface contact with the emission layer (EL).

3. The light emitting display device according to claim 1 or 2, further comprising:
an etch stopper layer (DACT) between the second anode electrode (ANOW) and the insulating layer (IL, GI) in the second pixel,
wherein the etch stopper layer (DACT) includes a material having higher anti-etching property than the insulating layer (IL. GI) against an etchant for patterning the insulating layer (IL, GI) to form the trench (SLT).

4. The light emitting display device according to claim 3, wherein the second anode electrode (ANOW) has shorter length than the etch stopper layer (DACT), and is disposed at a middle portion of the etch stopper layer (DACT), and
wherein the emission layer (EL) has a step shape along the etch stopper layer (DACT) and the second anode electrode (ANOW) in the second pixel.

5. The light emitting display device according to claim 3 or 4, wherein the insulating layer (GI) has an under-cut area (UC) which has a smaller area than the etch stopper layer (DACT) and is over etched under the etch stopper layer (DACT) from the trench (SLT).

6. The light emitting display device according to claim 5, wherein the emission layer (EL) is disconnected at the under-cut area (UC) between the first pixel (RP, GP, BP) and the second pixel.

7. The light emitting display device according to any of the preceding claims, wherein the first pixel (RP, GP, BP) is selected one of a red pixel (RP), a green pixel (GP), and a blue pixel (BP), and
wherein the second pixel is a white pixel (WP).

8. The light emitting display device according to claim 7, wherein the white pixel is disposed at any one of between the red pixel and the green pixel, between the green pixel and the blue pixel, and between the blue pixel and the red pixel.

9. The light emitting display device according to any of the preceding claims, further comprising:
a color filter (CF) layer between the planarization layer (PL) and the insulating layer (IL, GI); and
a driving element layer between the planarization layer (PL) and the substrate (110).

10. The light emitting display device according to claim 9, wherein the color filter (CF) layer includes a red color filter (CFR), a green color filter (CFG), and a blue color filter (CFB), and
wherein the first pixel (RP, GP, BP), except the second pixel, includes any one of the red color filter (CFR), the green color filter (CFG), and the blue color filter (CFB).

11. The light emitting display device according to claim 9 or 10, wherein the driving element layer includes:
a first driving element connected to the first anode electrode (ANOR, ANOG, ANOB); and
a second driving element connected to the second anode electrode (ANOW).

12. The light emitting display device according to claim 11, wherein each of the first driving element and the second driving element includes:
a gate electrode (SG, DG) on the substrate (110);
a gate insulating layer (GI) covering the gate electrode (SG, DG);
a semiconductor layer (SA, DA) overlapping with the gate electrode (SG, DG) on the gate insulating layer (GI);
an intermediate insulating layer (IL) covering the semiconductor layer (SA, DA);
a source electrode (SS, DS) connected to one side of the semiconductor layer (SA, DA) and a drain electrode (SD, DD) connected to another side of the semiconductor layer (SA, DA) on the intermediate insulating layer (IL); and
a passivation layer (PAS) covering the source electrode (SS, DS) and the drain electrode (SD, DD).

13. The light emitting display device according to any of the preceding claims, wherein the planarization layer (PL) is disposed within the first pixel (RP, GP, BP) except the second pixel,
wherein the trench (SLT) is disposed between a side wall of the planarization layer (PL) and a side wall of the insulating layer (IL, GI) to expose some of the substrate (110) between the first pixel (RP, GP, BP) and the second pixel, and
wherein the emission layer (EL) contacts the substrate via the trench (SLT).

14. The light emitting display device according to claim 13, wherein the second anode electrode (ANOW) is disposed at a closer position to the substrate (110) than the first anode electrode (ANOR, ANOG, ANOB), and
wherein a portion of the cathode electrode (CAT) disposed on the second anode electrode (ANOW) is disposed at a closer height to the substrate (110) than a portion of the cathode electrode (CAT) disposed on the first anode electrode (ANOR, ANOG, ANOB).

15. The light emitting display device according to any of the preceding claims 2 to 14, wherein the cathode electrode (CAT) has an inclined surface at the side wall of the protrusion with respect to a horizontal surface of the substrate (110) with an inclination angle θ in a range of 40 degrees to 80 degrees.
